# EUROPEAN PATENT SPECIFICATION

(11) **EP 3 534 510 B1**
(45) Date of publication and mention of the grant of the patent: **17.02.2021**
(21) Application number: 17864237.7
(22) Date of filing: 17.10.2017
(51) Int. Cl.: H02K 11/33, H01L 23/58, H01L 25/07, H01L 25/18, H02K 11/27, H02K 11/30

(54) **ROTATING ELECTRICAL MACHINE HAVING INTEGRATED CONTROL DEVICE**
ROTIERENDE ELEKTRISCHE MASCHINE MIT INTEGRIERTER STEUERUNGSVORRICHTUNG
MACHINE ÉLECTRIQUE TOURNANTE DOTÉE D'UN DISPOSITIF DE COMMANDE INTÉGRÉ

(30) Priority: 26.10.2016 JP 2016209432
(43) Date of publication of application: 04.09.2019
(73) Proprietor: Mitsubishi Electric Corporation, Chiyoda-ku Tokyo 100-8310 (JP)
(72) Inventor: MITSUI, Takao, Tokyo 100-8310 (JP); MIYAMOTO, Teruo, Tokyo 100-8310 (JP); KATO, Masaki, Tokyo 100-8310 (JP); KASHIHARA, Toshiaki, Tokyo 100-8310 (JP); SHIRAKATA, Yuji, Tokyo 100-8310 (JP); FUJII, Kenta, Tokyo 100-8310 (JP)
(74) Representative: Hoffmann Eitle
(86) International application number: PCT/JP2017/037606
(87) International publication number: WO 2018/079352

(56) References cited:
- WO-A1-2012/093476
- DE-A1-102008 033 519
- FR-A1- 2 949 626
- GB-A- 2 530 255
- JP-A- 2003 068 967
- JP-A- 2012 249 371
- US-B2- 7 969 052

## Description

### Technical Field

The present invention relates to a controller-integrated rotary electric machine, and more particularly, to a controller-integrated rotary electric machine configured to interrupt a short-circuit current that flows when a short-circuit fault occurs in a component thereof.

### Background Art

Hitherto, as a controller-integrated rotary electric machine in which a rotary electric machine and a controller configured to control the rotary electric machine are integrated, there has been known a controller-integrated rotary electric machine having the following configuration (see, for example, Patent Literature 1). The controller-integrated rotary electric machine includes a rotary electric machine main body and a controller. The rotary electric machine main body includes a stator, a rotor, and a supporting body. The rotor includes a rotating shaft and is rotatable relative to the stator. The supporting body is configured to support the stator and the rotor. The controller includes a power circuit portion, and is provided to the rotary electric machine main body. The power circuit portion is arranged around the rotating shaft, and is configured to convert electric power received from the rotary electric machine main body or electric power to be supplied to the rotary electric machine main body between an alternating current and a direct current.

Moreover, in Patent Literature 1, the following configuration is described. The power circuit portion includes power modules and an electric power interconnecting part. The power modules each include a switching element. The electric power interconnecting part includes conductors to be connected to terminals of the power modules. A positive busbar, which is one of the electric power interconnecting part, has an annular portion, a plurality of positive terminal connecting portions, and an electric power supply terminal portion. The annular portion surrounds the rotating shaft. The plurality of positive terminal connecting portions are formed on the annular portion so as to be spaced apart from each other, and positive terminals of the power modules are separately connected to the plurality of positive terminal connecting portions, for example, by welding. The electric power supply terminal portion is provided on the annular portion, and is electrically connected to a battery.

There has also been known a semiconductor device having the following configuration (see, for example, Patent Literature 2). The semiconductor device includes a switching element and power leads connected to main electrodes of the switching element. A narrow portion having a small cross-sectional area is formed in each of the power leads to form a fuse portion. When an overcurrent flows through the power leads, the fuse portion is blown to interrupt the overcurrent.

### Citation List

### Patent Literature

[PTL 1] JP 5730333 B2
[PTL 2] JP 2003-068967 A

GB 2 530 255 A, US 7,699,052 B2, FR 2 949 626 A1, and DE 10 2008 033519 A1 are further prior art.

### Summary of Invention

### Technical Problem

However, the related-art technologies have the following problem.

Specifically, consideration is made of the following case. The positive busbar being the electric power interconnecting part electrically connected to the electric power supply terminal portion, which is electrically connected to the battery, is connected to the terminals of the power modules. Further, a fuse portion, which is to be blown when the overcurrent flows, is formed in a portion of each of the terminals of the power modules. In this case, the fuse portion can be blown temporarily at the moment at which the overcurrent flows. However, the blown portion may reach a high temperature to be melted and brought into electrical contact with an electric power interconnecting part again. Therefore, there is a problem in that the fuse function is not achieved.

The present invention has been made to solve the above-mentioned problem, and has an object to provide a controller-integrated rotary electric machine capable of reliably interrupting an overcurrent.

### Solution to Problem

According to one embodiment of the present invention, there is provided a controller-integrated rotary electric machine having the features of claim 1.

### Advantageous Effects of Invention

According to one embodiment of the present invention, in the controller-integrated rotary electric machine, the controller includes a cooling member, and the power circuit portion includes the power module and the electric power interconnecting part. The power module includes the switching element. The electric power interconnecting part includes the conductor to be connected to the plurality of terminals of the power module. At least one of the plurality of terminals of the power module has the fuse portion. The fuse portion and the electric power interconnecting part are separated from each other. The electric power interconnecting part has the notch formed in the portion around which the plurality of terminals of the power module are placed. The part in which the plurality of terminals of the power module are not placed extends to the cooling member side.

The at least one of the terminals of the power module has the fuse portion, and the fuse portion and the electric power interconnecting part are separated from each other. Therefore, the fuse portion and the electric power interconnecting part are not brought into electrical contact with each other again, and hence a fuse function can be achieved.

Moreover, the electric power interconnecting part has the notch formed in the portion around which the terminals of the power module are placed, and the part in which the terminals of the power module are not placed extends to the cooling member side. Therefore, the electric power interconnecting part can be cooled by cooling the cooling member with a cooling fan of the rotary electric machine main body. Consequently, even under a high ambient temperature environment as in a case of being mounted in an internal combustion engine room for a vehicle, the increase in temperature of the electric power interconnecting part caused by the overcurrent is reduced, and thermal expansion of the electric power interconnecting part is suppressed. Thus, the fuse portion and the electric power interconnecting part are not brought into electrical contact, with the result that a synergistic effect is obtained as the fuse function.

Therefore, the present invention provides a controller-integrated rotary electric machine capable of interrupting an overcurrent reliably.

### Brief Description of Drawings

FIG. 1 is a sectional view for illustrating a controller-integrated rotary electric machine according to a first embodiment of the present invention.
FIG. 2 is a side view of the controller-integrated rotary electric machine illustrated in FIG. 1 as seen from a rear side.
FIG. 3 is a sectional view taken along the line A-A of FIG. 2 as seen in the direction indicated by the arrows.
FIG. 4 is a perspective view for illustrating a joint state between fuse portions and a positive busbar in a power circuit portion of the controller-integrated rotary electric machine according to the first embodiment of the present invention.

### Description of Embodiments

A description is now given of a controller-integrated rotary electric machine according to preferred embodiments of the present invention referring to the accompanying drawings, and throughout the drawings, the same or corresponding components are denoted by the same reference symbols to describe those components.

### First Embodiment

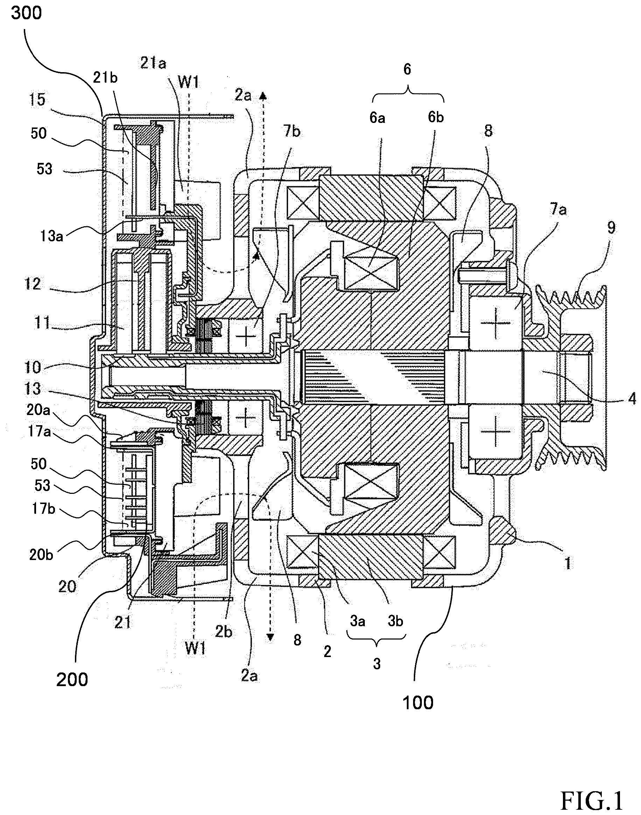

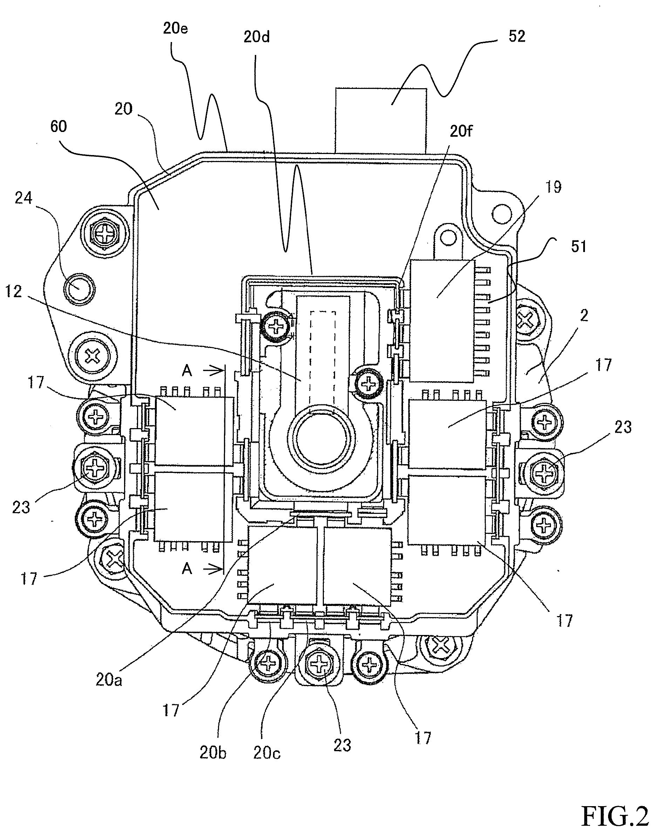

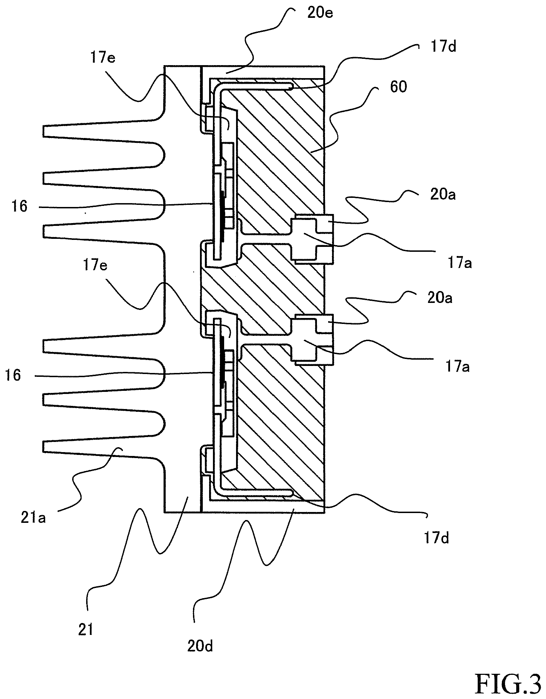

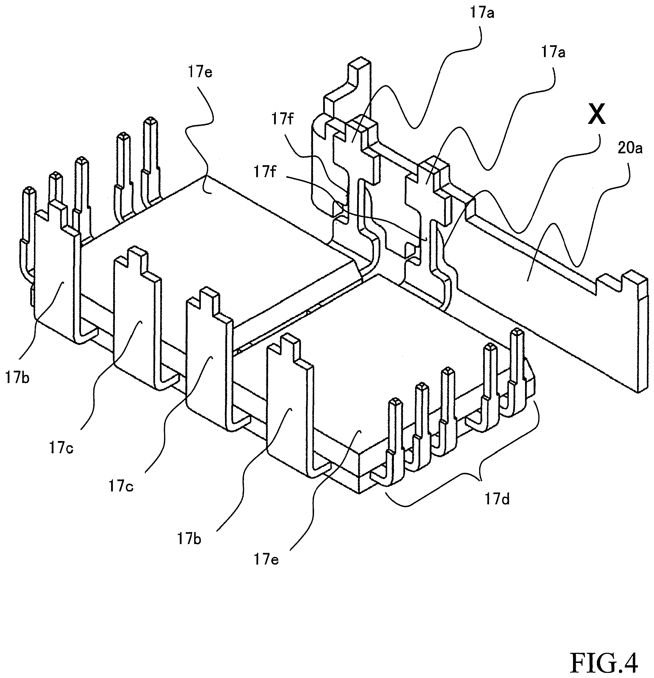

FIG. 1 is a sectional view for illustrating a controller-integrated rotary electric machine according to a first embodiment of the present invention. Moreover, FIG. 2 is a side view of the controller-integrated rotary electric machine illustrated in FIG. 1 as seen from a rear side. Moreover, FIG. 3 is a sectional view taken along the line A-A of FIG. 2 as seen in the direction indicated by the arrows, and is an illustration of power modules of a power circuit portion. Moreover, FIG. 4 is a perspective view for illustrating a joint state between fuse portions and a positive busbar in the power circuit portion of the controller-integrated rotary electric machine according to the first embodiment of the present invention.

In FIG. 1 to FIG. 4, a controller-integrated rotary electric machine 300 includes a rotary electric machine main body 100 and a controller 200 mounted to the rotary electric machine main body 100. In the first embodiment of the present invention, a description is given of an alternating-current generator-motor, that is, a motor generator as an example of the controller-integrated rotary electric machine 300.

The rotary electric machine main body 100 includes a stator 3, a rotor 6, and a case. The stator 3 has a tubular shape. The rotor 6 is arranged on an inner side of the stator 3 and is rotatable relative to the stator 3. The case is a supporting body configured to support the stator 3 and the rotor 6.

The case is formed of a front bracket 1 and a rear bracket 2, which receive the stator 3 fitted thereto in an axial direction of the rotor 6. Moreover, the front bracket 1 and the rear bracket 2 are made of, for example, aluminum.

The stator 3 includes a stator core 3b and a stator winding 3a. The stator core 3b has a tubular shape, and is connected to each of the front bracket 1 and the rear bracket 2. The stator winding 3a is an armature winding disposed on the stator core 3b.

The rotor 6 includes a rotating shaft 4, a rotor core 6b, and a rotor winding 6a. The rotating shaft 4 is arranged on an axis of the rotor 6. The rotor core 6b is fixed to an intermediate portion of the rotating shaft 4. The rotor winding 6a is a field winding disposed on the rotor core 6b.

The rotating shaft 4 passes through the front bracket 1 and the rear bracket 2. Moreover, the rotating shaft 4 is rotatably supported in the front bracket 1 and the rear bracket 2 through intermediation of bearings 7a and 7b, respectively.

An outer circumferential portion of the rotor core 6b faces an inner circumferential portion of the stator 3. Cooling fans 8 for sending air, which are configured to rotate together with the rotor 6, are disposed on the rotor core 6b. Moreover, an air inlet 2b and an air outlet 2a are formed in the rear bracket 2 so that air can be efficiently sent to cooling fins 21a of a heat sink 21, which is a cooling member disposed in the controller 200.

A pulley 9 is fixed to an end portion of the rotating shaft 4 on the front bracket 1 side. A transmitting belt (not shown) configured to operate interdependently with a rotating shaft of an engine is wound around the pulley 9. Moreover, a rotational position detecting sensor 13 configured to generate a signal corresponding to rotation of the rotating shaft 4 is disposed on an end portion of the rotating shaft 4 on the rear bracket 2 side.

Further, a plurality of slip rings 10, which are electrically connected to the rotor winding 6a, are disposed on a portion of the rotating shaft 4 that is on the rear side of the rotational position detecting sensor 13. The slip rings 10 are annular conductive members surrounding an outer circumferential portion of the rotating shaft 4.

Respective conductive brushes 11 configured to supply a field current for generating a magnetic field in the rotor 6 to the slip rings 10 is held in contact with the respective slip rings 10. A brush holder 12 configured to guide the brushes 11 in directions of separation from and contact with the respective slip rings 10 is disposed on the rear bracket 2.

Compressed springs configured to separately urge the respective brushes 11 in the direction of contact with the respective slip rings 10 are disposed in the brush holder 12. The respective brushes 11 are pressed against the slip rings 10 by the urging forces from the compressed springs. The slip rings 10 slide on the brushes 11 when the rotor 6 rotates.

The controller 200 is supported by the rear bracket 2. Moreover, the controller 200 includes power circuit portions 17, a field circuit portion 19, a control circuit portion 50, and signal relay terminals 51. The power circuit portions 17 are electrically connected to the stator winding 3a. The field circuit portion 19 is configured to adjust and supply electric power from a battery, which is a direct current power supply, to the rotor winding 6a as a field current. The control circuit portion 50 is configured to control each of the power circuit portions 17 and the field circuit portion 19. The signal relay terminals 51 are configured to transmit and receive control signals between the power circuit portion 17 and the control circuit portion 50 and between the field circuit portion 19 and the control circuit portion 50.

The signal from the rotational position detecting sensor 13 is transmitted to the control circuit portion 50 via the signal relay terminals 51. Moreover, a connector for external connection configured to transmit and receive signals to and from external equipment such as an engine control unit is disposed on the control circuit portion 50. The control circuit portion 50 is configured to control the field circuit portion 19 and the power circuit portions 17 based on information from each of the external equipment and the rotational position detecting sensor 13.

The field circuit portion 19 is configured to adjust the field current to the rotor winding 6a under control of the control circuit portion 50. The field current adjusted by the field circuit portion 19 is supplied to the rotor winding 6a in the rotor 6. The magnetic field is thereby generated in the rotor 6.

The power circuit portions 17 are each is configured to convert electric power received from the stator winding 3a or electric power to be supplied to the stator winding 3a between an alternating current and a direct current under control of the control circuit portion 50. Specifically, the power circuit portions 17 are each configured to convert direct-current power from the battery to alternating-current power and supply the converted power to the stator winding 3a, and convert alternating-current power from the stator winding 3a to direct-current power and supply the converted power to the battery under control of the control circuit portion 50.

The signal relay terminals 51 have signal wires respectively connected to the power circuit portions 17 and the field circuit portion 19. The transmission and reception of the signals between the power circuit portion 17 and the control circuit portion 50, and between the field circuit portion 19 and the control circuit portion 50 are performed through the signal relay terminals 51.

The power circuit portions 17 and the field circuit portion 19 are disposed on an outer side of the rear bracket 2. Moreover, the power circuit portions 17 and the field circuit portion 19 are arranged around the rotating shaft 4.

The power circuit portions 17 are devices arrayed in a substantially U shape surrounding the rotating shaft 4. Moreover, the power circuit portions 17 each include a plurality of power modules, an electric power interconnecting part 20, and the heat sink 21. The electric power interconnecting part 20 includes respective power wires for the power modules and the field circuit portion 19. The heat sink 21 receives the field circuit portion 19, the power modules, and the electric power interconnecting part 20, mounted thereto. In the first embodiment of the present invention, a description is given of a case in which six power modules are provided, as an example.

The heat sink 21 is a doughnut-shaped rotator having the rotating shaft 4 as its axis, and is supported by the rear bracket 2 so as to surround the rotating shaft 4. Moreover, a face of the heat sink 21 opposite to the rotor core 6b side is a common mounting face 21b which receives the field circuit portion 19, the power modules of the power circuit portions 17, and the electric power interconnecting part 20 mounted thereto. The mounting face 21b of the heat sink 21 is a flat face that is perpendicular to an axis of the rotating shaft 4.

Moreover, the cooling fins 21a are disposed on a face of the heat sink 21 on the rotor core 6b side. With the cooling fans 8 provided in the rotary electric machine main body 100, outside air is taken in as cooling air W1 in a radial direction, and heat from the field circuit portion 19, the power modules of the power circuit portions 17, and the electric power interconnecting part 20 is radiated to outside air by the heat sink 21 and the cooling fins 21a.

Moreover, a cover 15 is mounted so as to surround the electric power interconnecting part 20, the slip rings 10, and the brushes 11. The cover 15 serves to prevent entry of foreign matters from the outside.

A plurality of opening portions 53 for receiving the field circuit portion 19 or the power modules of the power circuit portions 17 disposed therein are formed in the electric power interconnecting part 20. The field circuit portion 19 and the power modules of the power circuit portions 17 are mounted to the mounting face 21b of the heat sink 21 so as to be disposed in the opening portions 53.

Therefore, the electric power interconnecting part 20 is disposed so as to avoid overlapping with the respective regions of the field circuit portion 19 and the power modules of the power circuit portions 17 when the power circuit portion 17 is viewed in an axial direction of the rotating shaft 4.

In other words, the electric power interconnecting part 20 is disposed outside the respective regions of the field circuit portion 19 and the power modules of the power circuit portions 17 so as not to overlap any region of the field circuit portion 19 and the power modules of the power circuit portions 17 when the power circuit portion 17 is viewed in the axial direction of the rotating shaft 4.

The field circuit portion 19 and the power modules of the power circuit portions 17 are disposed so as to be spaced apart from each other in a circumferential direction of the rotating shaft 4 and surround the rotating shaft 4. The power modules of the power circuit portions 17 each include a module main body 17e, a positive terminal 17a, a negative terminal 17c, an AC terminal 17b, and a plurality of signal terminals 17d. The module main body 17e includes a switching element 16 and has a flat rectangular parallelepiped shape. The positive terminal 17a, the negative terminal 17c, the AC terminal 17b, and the plurality of signal terminals 17d protrude from the module main body 17e.

A power transistor, a field-effect transistor (metal-oxide-semiconductor field-effect transistor: MOSFET), or an insulated gate bipolar transistor (IGBT) is used as the switching element 16, for example. The power circuit portions 17 are each configured to convert the electric power between an alternating current and a direct current by repeating ON/OFF switching operations using the switching element 16.

The module main body 17e is produced by integrating a plurality of switching elements 16 with an insulating resin by insert molding. The module main body 17e is disposed so as to have a thickness direction that is oriented in the axial direction of the rotating shaft 4. Among four side faces of the module main body 17e, the positive terminal 17a is disposed on a side face that is close to the rotating shaft 4. The negative terminal 17c and the AC terminal 17b are disposed on a side face that is away from the rotating shaft 4. The signal terminals 17d are disposed on the remaining two side faces.

A fuse portion is formed in the positive terminal 17a protruding from the module main body 17e. The fuse portion is formed by forming a narrow portion 17f in a portion of the positive terminal 17a. When an overcurrent flows through the positive terminal 17a, the fuse portion is blown to interrupt the overcurrent. Without being limited thereto, the positive terminal 17a may be formed through stamping of a plate made of copper or a copper alloy.

The electric power interconnecting part 20 includes a positive busbar 20a, a plurality of negative busbars 20c, armature connecting terminals 20b, and a plurality of field connecting terminals 20f as a plurality of conductors, and an outer frame having a hollow case shape so as to hold the positive busbar 20a, the negative busbars 20c, the armature connecting terminals 20b, and the field connecting terminals 20f, is coupled with a thermoplastic resin as an insulator, and is cast into a hollow portion thereof with a thermosetting resin.

The positive busbar 20a, the negative busbars 20c, the armature connecting terminals 20b, and the field connecting terminals 20f are integrated by insert molding. Moreover, the positive busbar 20a, the negative busbars 20c, the armature connecting terminals 20b, and the field connecting terminals 20f are the power wires for the power modules of the power circuit portions 17 and the field circuit portion 19.

Moreover, the positive busbar 20a, the negative busbars 20c, the armature connecting terminals 20b, and the field connecting terminals 20f are arranged to be spaced apart from each other when the electric power interconnecting part 20 is viewed in the axial direction of the rotating shaft 4. The positive busbar 20a is arranged at a position on a radially inner side of the field circuit portion 19 and the power modules of the power circuit portions 17. The negative busbars 20c and the armature connecting terminals 20b are arranged at positions on a radially outer side of the field circuit portion 19 and the power modules of the power circuit portions 17.

Moreover, the positive busbar 20a is formed as an annular portion surrounding the rotating shaft 4, and includes a plurality of positive terminal connecting portions, to which the positive terminals 17a of the power modules of the power circuit portions 17 and the field connecting terminals 20f of the field circuit portion 19 are separately connected by welding, for example, and an electric power supply terminal portion 24 to be electrically connected to the battery.

Moreover, the positive busbar 20a has a notch X formed in a portion around which the positive terminals 17a of the power modules of the power circuit portions 17 are connected so that the positive busbar 20a is separated from the narrow portions 17f of the positive terminals 17a of the power modules of the power circuit portions 17. Moreover, a part of the positive busbar 20a to which the positive terminals 17a of the power modules of the power circuit portions 17 are not connected extends in an axial direction on the heat sink 21 side, and has an end portion having such a width as to reach a height position of a face of the module main body 17e in a thickness direction of the module main body 17e.

The notch X is at least cut out to above a center of the fuse portion of the positive terminal 17a. This is because the fuse is blown at the center of the fuse portion. Moreover, a width of the notch X is at least larger than a width of the fuse portion, but is required to be determined depending on assembling precision.

The positive terminals 17a of the power modules of the power circuit portions 17 and the electric power supply terminal portion 24 protrude from the annular portion in the axial direction of the rotating shaft 4. The positive terminals 17a of the power modules of the power circuit portions 17 and the field connecting terminals 20f of the field circuit portion 19 extend in parallel. The annular portion is formed through bending of a strip-shaped conductor such that the thickness direction matches the radial direction.

The positive busbar 20a is produced through bending of a strip-shaped conductor, which is a metal sheet on which the positive terminals 17a of the power modules of the power circuit portions 17 and the electric power supply terminal portion 24 are disposed and through connecting end portions together. The positive busbar 20a is integrated with the insulator forming the electric power interconnecting part 20 in a state in which the positive terminals 17a of the power modules of the power circuit portions 17 and the electric power supply terminal portion 24 are exposed from the insulator.

The negative busbars 20c have negative terminal connecting portions to which the negative terminals 17c of the power modules of the power circuit portions 17 are connected by welding, for example. The negative terminals 17c of the power modules of the power circuit portions 17 protrude in the axial direction of the rotating shaft 4, and extend in parallel to each other. In each of the negative busbars 20c, a through hole for a bolt through which a bolt 23 is fixed to the heat sink 21 is formed.

The negative busbars 20c are produced through bending of flat metal segments. Moreover, the negative busbars 20c are integrated with the insulator forming the electric power interconnecting part 20 in a state in which portions around the bolts 23 are exposed from the insulator.

The electric power interconnecting part 20 and the heat sink 21 are fastened mechanically and collectively to the rear bracket 2 by the bolts 23. The negative busbars 20c are grounded to the rear bracket 2 by being fastened mechanically to the rear bracket 2 by the bolts 23.

The armature connecting terminals 20b are electrically connected to the stator winding 3a, and include AC terminal connecting portions, which are connected to the AC terminals 17b of the power modules of the power circuit portions 17 by welding, for example. The armature connecting terminals 20b are produced through bending of flat metal segments. Moreover, the armature connecting terminals 20b are integrated with the insulator in a state in which the AC terminal connecting portions are exposed from the insulator. The AC terminals 17b of the power modules of the power circuit portions 17 extend in parallel to the AC terminal connecting portions.

The field connecting terminals 20f are electrically connected to the rotor winding 6a via the brushes 11 and the slip rings 10. The field connecting terminals 20f are produced through bending of flat metal segments. Moreover, the field connecting terminals 20f are integrated with the insulator forming the electric power interconnecting part 20 in a state in which a field terminal connecting portion is exposed from the insulator. The field connecting terminals 20f of the field circuit portion 19 extend in parallel to the field terminal connecting portion.

The insulator forming the electric power interconnecting part 20 is formed in an annular shape such that the rotating shaft 4 passes therethrough centrally. Moreover, the opening portions 53 are formed so as to avoid the positive busbar 20a, the negative busbars 20c, the armature connecting terminals 20b, and the field connecting terminals 20f. Moreover, the insulator forming the electric power interconnecting part 20 is mounted to the heat sink 21 in a state of being held in contact with the mounting face 21b of the heat sink 21.

Moreover, the insulator forming the electric power interconnecting part 20 is arranged at a position that overlaps with regions of the power modules of the power circuit portions 17 and the field circuit portion 19 when the power circuit portion 17 is viewed in a direction perpendicular to the axis of the rotating shaft 4, that is, the radial direction. In other words, the insulator case, the power modules of the power circuit portions 17, and the field circuit portion 19 are arranged on the common flat face that is perpendicular to the axis of the rotating shaft 4.

Moreover, the electric power interconnecting part 20 has an inner wall portion 20d surrounding the rotating shaft 4, and an outer wall portion 20e surrounding the power modules of the power circuit portions 17 and the field circuit portion 19 together. The inner wall portion 20d and the outer wall portion 20e are brought into direct contact with the heat sink 21 to define recess portions. The field circuit portion 19 and the power modules of the power circuit portions 17 are disposed in the recess portions defined between the inner wall portion 20d and the outer wall portion 20e.

The signal terminals 17d are disposed in the recess portions, which are defined between the inner wall portion 20d and the outer wall portion 20e, in a state of being parallel to the field circuit portion 19 and the power modules of the power circuit portions 17.

The recess portions defined between the inner wall portion 20d and the outer wall portion 20e are filled with an insulating filler 60. The field circuit portion 19, the signal terminals 17d, and the power modules of the power circuit portions 17 are thereby embedded in the filler 60. The filler 60 can be formed using any thermosetting resin material, and it is preferred that the filler 60 be formed using an epoxy resin containing an alumina or a silicon compound having high heat conductivity as a filler, for example.

Through filling with the filler 60, the narrow portions 17f formed in the positive terminals 17a protruding from the module main body 17e and the positive busbar 20a are coupled to each other via the filler 60. Moreover, the narrow portions 17f of adjacent power modules are covered with a resin having an elastic modulus that is lower than that of power module terminals to couple a plurality of module terminals to each other by the filler 60.

Next, operation is described. The power circuit portions 17 and the field circuit portion 19 are controlled by the control circuit portion 50 based on information from the rotational position detecting sensor 13 and the external equipment.

When the engine is started, the direct-current power from the battery is supplied to each of the power circuit portions 17 and the field circuit portion 19. In the field circuit portion 19, operation of adjusting the direct-current power from the battery to the field current is performed under the control of the control circuit portion 50. The field current from the field circuit portion 19 is supplied to the rotor winding 6a via the brushes 11 and the slip rings 10. A direct current magnetic field is thereby generated in the rotor 6.

Meanwhile, switching operation is performed in the respective power modules of the power circuit portions 17 under the control of the control circuit portion 50. The direct-current power from the battery is thereby converted to the alternating-current power. The alternating-current power obtained as a result of the conversion in the power circuit portions 17 is supplied to the stator winding 3a. A rotating magnetic field is thereby generated in the stator 3 to rotate the rotor 6. Moreover, the pulley 9 is rotated with the rotation of the rotor 6 to start the engine.

After the engine is started, torque from the engine is transmitted to the pulley 9. The rotor 6 is thereby rotated to induce the alternating-current power in the stator winding 3a. At this time, in the respective power modules of the power circuit portions 17, the switching operation is performed under the control of the control circuit portion 50. The alternating-current power induced in the stator winding 3a is thereby converted to the direct-current power. The direct-current power from the power circuit portions 17 is subsequently charged to the battery.

In the first embodiment of the present invention, at least one of the terminals of the power module has the fuse portion, and the fuse portion and the electric power interconnecting part 20 are separated from each other. Therefore, the fuse portion and the electric power interconnecting part 20 are not brought into electrical contact with each other again, and hence a fuse function can be achieved.

Moreover, the electric power interconnecting part 20 has the notch X formed in the portion around which the terminals of the power module are placed, and the part in which the terminals of the power module are not placed extends to the heat sink 21 side. Therefore, the electric power interconnecting part 20 can be cooled by cooling the heat sink 21 with the cooling fans 8 of the rotary electric machine main body 100. Consequently, even under a high ambient temperature environment as in a case of being mounted in an internal combustion engine room for a vehicle, the increase in temperature of the electric power interconnecting part 20 caused by the overcurrent is reduced, and thermal expansion of the electric power interconnecting part 20 is suppressed. Thus, the fuse portion and the electric power interconnecting part 20 are not brought into electrical contact, with the result that a synergistic effect is obtained as the fuse function.

Moreover, through filling with the filler, the narrow portions 17f formed in the positive terminals 17a protruding from the module main body and the positive busbar 20a are coupled to each other via the filler, with the result that no gaseous discharge phenomenon occurs, and that reliability of a fuse function is increased. Moreover, in an application for a vehicle, entry of chloride fog caused by spraying of a snow-melting agent can be prevented, with the result that short circuit of the narrow portions 17f caused by electrolytic corrosion does not occur, and that reliability of the fuse function is increased.

Moreover, a space between the narrow portions 17f of the adjacent power modules is covered with the resin having the elastic modulus that is lower than that of the power module terminals to couple the plurality of module terminals to each other with the resin, with the result that, even when the controller-integrated rotary electric machine is mounted directly to the internal combustion engine of the vehicle, the narrow portions 17f is not short-circuited by conduction of the vibration of the internal combustion engine, and that the reliability of the fuse function is increased.

As described above, according to the first embodiment, in the controller-integrated rotary electric machine, the controller includes a cooling member, and the power circuit portion includes the power module and the electric power interconnecting part. The power module includes the switching element. The electric power interconnecting part includes the conductor to be connected to the plurality of terminals of the power module. At least one of the plurality of terminals of the power module has the fuse portion. The fuse portion and the electric power interconnecting part are separated from each other. The electric power interconnecting part has the notch formed in the portion around which the plurality of terminals of the power module are placed. The part in which the plurality of terminals of the power module are not placed extends to the cooling member side.

Therefore, a controller-integrated rotary electric machine capable of interrupting an overcurrent reliably is provided.

### Reference Signs List

1 front bracket, 2 rear bracket, 2a air outlet, 2b air inlet, 3 stator, 3a stator winding, 3b stator core, 4 rotating shaft, 6 rotor, 6a rotor winding, 6b rotor core, 7a, 7b bearing, 8 cooling fan, 9 pulley, 10 slip ring, 11 brush, 12 brush holder, 13 rotational position detecting sensor, 15 cover, 16 switching element, 17 power circuit portion, 17a positive terminal, 17b AC terminal, 17c negative terminal, 17d signal terminal, 17e module main body, 17f narrow portion, 19 field circuit portion, 20 electric power interconnecting part, 20a positive busbar, 20b armature connecting terminal, 20c negative busbar, 20d inner wall portion, 20e outer wall portion, 20f field connecting terminal, 21 heat sink, 21a cooling fin, 21b mounting face, 23 bolt, 24 electric power supply terminal portion, 50 control circuit portion, 51 signal relay terminal, 53 opening portion, 60 filler, 100 rotary electric machine main body, 200 controller, 300 controller-integrated rotary electric machine, X notch

## Claims

1. A controller-integrated rotary electric machine (300), comprising:
a rotary electric machine main body (100) including:
a stator (3);
a rotor (6), which includes a rotating shaft (4) and is rotatable relative to the stator; and
a supporting body (1, 2), which is configured to support the stator and the rotor; and
a controller (200) including a power circuit portion (17) and being disposed on the rotary electric machine main body, the power circuit portion being arranged around the rotating shaft and being configured to convert electric power received from the rotary electric machine main body or electric power to be supplied to the rotary electric machine main body between an alternating current and a direct current,
the controller including a cooling member (21),
the power circuit portion including:
a power module, which includes a switching element (16); and
an electric power interconnecting part (20), which includes a busbar (20a) that is connected to a plurality of terminals (17a, 17b, 17c, 17d) of the power module,
at least one of the plurality of terminals of the power module having a fuse portion (17f) formed by forming a narrow portion (17f) in a portion of at least one of the plurality of terminals (17a, 17b, 17c, 17d),
the electric power interconnecting part (20) having a notch (X) formed in a portion around which at least one of the plurality of terminals are connected so that the busbar (20a) is separated from the narrow portion (17f) of the at least one of the plurality of terminals (17a), wherein the notch (X) is at least cut out to above a center of the fuse portion of the at least one of the plurality of terminals (17a) and a width of the notch (X) is at least larger than a width of the fuse portion (17f),
the electric power interconnecting part (20) further having a part in which the plurality of terminals (17a, 17b, 17c, 17d) of the power module are not placed extending to the cooling member (21) side.

2. The controller-integrated rotary electric machine according to claim 1, wherein the fuse portion and the electric power interconnecting part are separated from each other across a part filled with a filler (60).

3. The controller-integrated rotary electric machine according to claim 1 or 2, wherein the fuse portion is covered with a resin having an elastic modulus that is lower than an elastic modulus of the plurality of terminals of the power module, and the plurality of terminals of the power module are coupled to each other with the resin.

## Patentansprüche

1. Rotierende elektrische Maschine (300) mit integrierter Steuerung, aufweisend:
einen Hauptkörper (100) der rotierenden elektrischen Maschine, aufweisend:
einen Stator (3);
einen Rotor (6), der eine Drehwelle (4) aufweist und relativ zu dem Stator drehbar ist; und
einen Tragkörper (1, 2), der so konfiguriert ist, dass er den Stator und den Rotor trägt; und
eine Steuerung (200), die einen Leistungsschaltungsabschnitt (17) aufweist und an dem Hauptkörper der rotierenden elektrischen Maschine angeordnet ist, wobei der Leistungsschaltungsabschnitt um die Drehwelle herum angeordnet und so konfiguriert ist, dass er elektrische Leistung, die von dem Hauptkörper der rotierenden elektrischen Maschine empfangen wird, oder elektrische Leistung, die dem Hauptkörper der rotierenden elektrischen Maschine zuzuführen ist, zwischen einem Wechselstrom und einem Gleichstrom umwandelt,
wobei die Steuerung ein Kühlelement (21) aufweist,
wobei der Leistungsschaltungsabschnitt aufweist:
ein Leistungsmodul, das ein Schaltelement (16) aufweist; und
ein Verbindungsteil (20) für elektrische Leistung, das eine Sammelschiene (20a) aufweist, die mit einer Vielzahl von Anschlüssen (17a, 17b, 17c, 17d) des Leistungsmoduls verbunden ist,
wobei zumindest einer der Vielzahl von Anschlüssen des Leistungsmoduls einen Sicherungsabschnitt (17f) aufweist, der durch Ausbilden eines schmalen Abschnitts (17f) in einem Abschnitt von zumindest einem der Vielzahl von Anschlüssen (17a, 17b, 17c, 17d) gebildet ist,
wobei das Verbindungsteil (20) für elektrische Leistung eine Kerbe (X) aufweist, die in einem Abschnitt ausgebildet ist, um den herum zumindest einer der Vielzahl von Anschlüssen angeschlossen ist, sodass die Sammelschiene (20a) von dem schmalen Abschnitt (17f) des zumindest einen der Vielzahl von Anschlüssen (17a) getrennt ist, wobei die Kerbe (X) zumindest bis oberhalb einer Mitte des Sicherungsabschnitts des zumindest einen der Vielzahl von Anschlüssen (17a) ausgeschnitten ist und eine Breite der Kerbe (X) zumindest größer als eine Breite des Sicherungsabschnitts (17f) ist,
wobei das Verbindungsteil (20) für elektrische Leistung ferner einen Teil aufweist, in dem die Vielzahl von Anschlüssen (17a, 17b, 17c, 17d) des Leistungsmoduls nicht bis zur Seite des Kühlkörpers (21) verlaufend platziert sind.

2. Rotierende elektrische Maschine mit integrierter Steuerung nach Anspruch 1, wobei der Sicherungsabschnitt und das Verbindungsteil für elektrische Leistung über einen mit einem Füllstoff (60) gefüllten Teil voneinander getrennt sind.

3. Rotierende elektrische Maschine mit integrierter Steuerung nach Anspruch 1 oder 2, wobei der Sicherungsabschnitt mit einem Kunstharz mit einem Elastizitätsmodul, das niedriger ist als ein Elastizitätsmodul der Vielzahl von Anschlüssen des Leistungsmoduls, bedeckt ist und die Vielzahl von Anschlüssen des Leistungsmoduls mit dem Kunstharz miteinander gekoppelt sind.

## Revendications

1. Machine électrique rotative à dispositif de commande intégré (300) comprenant :
un corps principal de machine électrique rotative (100) incluant :
un stator (3) ;
un rotor (6) qui inclut un arbre tournant (4) et qui peut tourner par rapport au stator ; et
un corps de support (1, 2) qui est configuré pour supporter le stator et le rotor ; et
un dispositif de commande (200) incluant une partie de circuit d'énergie (17) et étant disposé sur le corps principal de machine électrique rotative, la partie de circuit d'énergie étant agencée autour de l'arbre tournant et étant configurée pour convertir l'énergie électrique reçue du corps principal de machine électrique rotative ou l'énergie électrique qui doit être fournie au corps principal de machine électrique rotative entre un courant alternatif et un courant continu,
le dispositif de commande incluant un élément de refroidissement (21),
la partie de circuit d'énergie incluant :
un module d'alimentation qui inclut un élément de commutation (16) ; et
une partie d'interconnexion d'énergie électrique (20), qui inclut une barre omnibus (20a) qui est raccordée à une pluralité de bornes (17a, 17b, 17c, 17d) du module d'alimentation,
au moins une de la pluralité de bornes du module d'alimentation présentant une partie fusible (17f) formée par formation d'une partie étroite (17f) dans une partie d'au moins une de la pluralité de bornes (17a, 17b, 17c, 17d),
la partie d'interconnexion d'énergie électrique (20) présentant une encoche (X) formée dans une partie autour de laquelle au moins une de la pluralité de bornes est raccordée de telle sorte que la barre omnibus (20a) soit séparée de la partie étroite (17f) de la au moins une de la pluralité de bornes (17a), dans laquelle l'encoche (X) est au moins coupée pour être au-dessus d'un centre de la partie fusible de la au moins une de la pluralité de bornes (17a), et une largeur de l'encoche (X) est au moins plus large qu'une largeur de la partie fusible (17f),
la partie d'interconnexion d'énergie électrique (20) présentant en outre une partie dans laquelle la pluralité de bornes (17a, 17b, 17c, 17d) du module d'alimentation ne sont pas placées de sorte à s'étendre vers le côté élément de refroidissement (21).

2. Machine électrique rotative à dispositif de commande intégré selon la revendication 1, dans laquelle la partie fusible et la partie d'interconnexion d'énergie électrique sont séparées l'une de l'autre à travers une partie remplie d'un produit de remplissage (60).

3. Machine électrique rotative à dispositif de commande intégré selon la revendication 1 ou 2, dans laquelle la partie fusible est recouverte d'une résine présentant un module élastique qui est inférieur à un module élastique de la pluralité de bornes du module d'alimentation et la pluralité de bornes du module d'alimentation sont couplées les unes aux autres avec la résine.
